# EUROPÄISCHE PATENTSCHRIFT

(11) **EP 4 066 384 B1**
(45) Veröffentlichungstag und Bekanntmachung des Hinweises auf die Patenterteilung: **31.07.2024**
(21) Anmeldenummer: 20816154.7
(22) Anmeldetag: 27.11.2020
(51) Int. Cl.: H03K 17/96, E05B 81/78

(54) **VORRICHTUNG FÜR EIN FAHRZEUG ZUR DETEKTION EINER AKTIVIERUNGSHANDLUNG IN MINDESTENS ZWEI UNTERSCHIEDLICHEN DETEKTIONSBEREICHEN**
APPARATUS FOR A VEHICLE FOR DETECTING AN ACTIVATION ACTION IN AT LEAST TWO DIFFERENT DETECTION REGIONS
DISPOSITIF POUR UN VÉHICULE POUR DÉTECTER UNE ACTION D'ACTIVATION DANS AU MOINS DEUX ZONES DE DÉTECTION DIFFÉRENTES

(30) Priorität: 27.11.2019 DE 102019132136
(43) Veröffentlichungstag der Anmeldung: 05.10.2022
(73) Patentinhaber: Huf Hülsbeck & Fürst GmbH & Co. KG, 42551 Velbert (DE)
(72) Erfinder: SIEG, Berthold, 46240 Bottrop (DE)
(74) Vertreter: Bals & Vogel Patentanwälte PartGmbB
(86) Internationale Anmeldenummer: PCT/EP2020/083704
(87) Internationale Veröffentlichungsnummer: WO 2021/105406

(56) Entgegenhaltungen:
- WO-A1-2018/177580
- DE-A1- 10 212 794
- DE-B4- 10 262 353
- US-A1- 2003 107 473
- US-A1- 2013 033 362

## Beschreibung

Die vorliegende Erfindung betrifft eine Vorrichtung gemäß der im Oberbegriff des Anspruchs 1 näher definierten Art. Ferner bezieht sich die Erfindung auf einen Türgriff mit der Vorrichtung.

Es ist aus dem Stand der Technik bekannt, dass bei Fahrzeugen Aktivierungshandlungen eines Benutzers genutzt werden können, um Funktionen des Fahrzeuges zu aktivieren. Eine derartige Aktivierungshandlung kann z. B. die Annäherung einer Hand an den Türgriff des Fahrzeuges sein, um eine Entriegelung und/oder Verriegelung des Fahrzeuges durchzuführen. Um diese Aktivierungshandlung zu detektieren, werden häufig Annäherungssensoren wie kapazitive Sensoren in den Türgriff des Fahrzeuges integriert.

Die Druckschriften US 2003/107473 A1, DE 102 12 794 A1, US 2013/033362 A1, DE 102 62 353 B4 und WO 2018/177580 A1 offenbaren relevanten Stand der Technik.

Es ist auch möglich, dass mehrere Sensoren vorgesehen sind, um unterschiedliche Detektionsbereiche zu überwachen, in denen die Aktivierungshandlung durchgeführt werden kann. Ein Problem kann hierbei allerdings sein, dass die Erfassung der Sensoren sich gegenseitig stören kann. Zum Beispiel kann eine erste Aktivierungshandlung in einem ersten Detektionsbereich eines ersten Sensors auch - ungewünscht - die Erfassung eines zweiten Sensors in einem zweiten Detektionsbereich beeinflussen.

Es ist daher eine Aufgabe der vorliegenden Erfindung, die voranstehend beschriebenen Nachteile zumindest teilweise zu beheben. Insbesondere ist es Aufgabe der vorliegenden Erfindung, eine verbesserte und insbesondere zuverlässigere Detektion solcher Aktivierungshandlungen zu ermöglichen.

Die voranstehende Aufgabe wird gelöst durch eine Vorrichtung mit den Merkmalen des unabhängigen Vorrichtungsanspruchs und durch einen Türgriff mit den Merkmalen des weiteren unabhängigen Vorrichtungsanspruchs. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Vorrichtung beschrieben sind, selbstverständlich auch im Zusammenhang mit dem erfindungsgemäßen Türgriff, und jeweils umgekehrt, so dass bezüglich der Offenbarung zu den einzelnen Erfindungsaspekten stets wechselseitig Bezug genommen wird bzw. werden kann.

Die Aufgabe wird erfindungsgemäß gelöst durch eine Vorrichtung für ein Fahrzeug zur Detektion (mindestens) einer Aktivierungshandlung in mindestens zwei unterschiedlichen Detektionsbereichen, und insbesondere zur Montage an einem Fahrzeugteil. Die Detektion der (mindestens einen) Aktivierungshandlung kann dazu dienen, um mindestens eine und bevorzugt zwei unterschiedliche Funktion(en) des Fahrzeuges in Abhängigkeit von der Detektion zu aktivieren.

Die Montage an dem Fahrzeugteil kann vorteilhafterweise dafür erfolgen, um im Bereich dieses Fahrzeugteils die Detektionsbereiche entstehen zu lassen. Das Fahrzeugteil ist z. B. ein erfindungsgemäßer Türgriff, in welchem die Vorrichtung aufgenommen ist, oder auch eine Tür oder Klappe oder ein Stoßfänger oder ein Türschweller des Fahrzeuges.

Die Detektion einer (ersten) Aktivierungshandlung in dem ersten Detektionsbereich kann ferner dazu dienen, eine (erste) Funktion des Fahrzeuges in Abhängigkeit von der Detektion zu aktivieren. Es kann auch vorgesehen sein, dass eine (zweite) Aktivierungshandlung in dem zweiten Detektionsbereich detektiert wird, um zumindest eine (zweite oder weitere) Funktion des Fahrzeuges zu aktivieren, wobei sich dann die Funktionen voneinander unterscheiden können. Die aktivierbare (erste und/oder wenigstens zweite) Funktion des Fahrzeuges ist z. B. wenigstens eine der folgenden:
- Eine Verrieglung des Fahrzeuges,
- Eine Entriegelung des Fahrzeuges,
- Die Initiierung einer Öffnungs- und/oder Schließbewegung eines beweglichen Teils des Fahrzeuges, insbesondere einer Front- oder Heck- oder Seitenklappe (wie einer Seitentür oder eines Kofferraumdeckels) des Fahrzeuges, wobei die Bewegung vorzugsweise motorisiert durchgeführt wird,
- Die Aktivierung einer Fahrzeugbeleuchtung,
- Die Initiierung einer Authentifizierung beim Fahrzeug.

Die erste und wenigstens zweite Funktion können dabei auch unterschiedliche der genannten Funktionen sein. Damit ist es z. B. möglich, dass die Detektion der ersten Aktivierungshandlung die Aktivierung einer anderen Funktion des Fahrzeuges auslöst als die Detektion der zweiten Aktivierungshandlung. Bspw. kann die Detektion einer Annäherung an eine erste Außenseite des Türgriffs (als die erste Aktivierungshandlung) die Verriegelung und die Detektion einer Annäherung an eine zweite Außenseite des Türgriffs (als die zweite Aktivierungshandlung) die Entriegelung auslösen. Die zweite Außenseite kann dabei einer Türgriffmulde zugewandt und die erste Außenseite der Türgriffmulde abgewandt sein (oder umgekehrt). Dies ermöglicht eine komfortable und einfache Bedienung der Funktionen für einen Benutzer des Fahrzeuges.

Eine erfindungsgemäße Vorrichtung weist ferner nachfolgend genannte Komponenten auf:
- eine (mehrlagige) Leiterplatte mit mehreren Lagen, wobei die Lagen vorzugsweise in einer axialen Richtung übereinander angeordnet - insbesondere aufeinander befestigt, vorzugsweise aufeinander geklebt - sind,
- ein erstes elektrisch leitendes Sensorelement zur kapazitiven Erfassung in einem ersten der Detektionsbereiche (d. h. einem ersten Detektionsbereich),
- ein zweites elektrisch leitendes Sensorelement zur kapazitiven Erfassung in einem zweiten der Detektionsbereiche (d. h. einem zweiten Detektionsbereich).

Es ist erfindungsgemäß vorgesehen, dass die Sensorelemente an unterschiedlichen der Lagen der Leiterplatte angeordnet sind. Erfindungsgemäß sind die Sensorelemente zumindest teilweise deckungsgleich (also jeweils mit einem deckungsgleichen Bereich) ausgebildet, wobei die deckungsgleichen Bereiche der Sensorelemente in einer lateralen Richtung x (d. h. insbesondere bezüglich ihrer Position auf der jeweiligen Lage) zueinander versetzt positioniert sind. Dies hat den Vorteil, dass eine Störung durch die kapazitive Erfassung des ersten Sensorelements auf die kapazitive Erfassung des zweiten Sensorelements und/oder umgekehrt zumindest reduziert werden kann. Die Aktivierungshandlung im ersten Detektionsbereich hat damit nur einen zumindest reduzierten Einfluss auf die Erfassung des zweiten Sensorelements im zweiten Detektionsbereich, und/oder umgekehrt.

Die Sensorelemente können vollständig deckungsgleich ausgebildet sein, sodass die deckungsgleiche Bereiche jeweils dem vollständigen Sensorelement entsprechen. Vorteilhaft ist es jedoch, wenn eines der Sensorelemente (bspw. das zweite Sensorelement) eine andere Ausbildung, bspw. eine längere Erstreckung, aufweist als das andere Sensorelement (bspw. das erste Sensorelement). In diesem Fall kann zumindest einer der deckungsgleichen Bereiche nur einem Teilbereich des zugehörigen Sensorelements entsprechen. Wenn gemäß diesem Beispiel die Sensorelemente eine unterschiedlich lange Erstreckung aufweisen, kann der deckungsgleiche Bereich des kürzeren Sensorelements auch dem vollständigen (kürzeren) Sensorelement entsprechen. Hingegen kann der deckungsgleiche Bereich des längeren Sensorelements nur dem teilweisen (längeren) Sensorelement entsprechen.

Im Rahmen dieser Erfindung können drei zueinander orthogonale Richtungen x, y, z definiert sein, nämlich zwei zueinander orthogonale laterale Richtungen x und y, sowie eine zu diesen Richtungen ebenfalls orthogonale axiale Richtung z. Insbesondere die lateralen Richtungen x und y definieren eine Ebene, in welcher eine Positionierung von elektronischen Bauelementen und Leiterbahnen auf einer einzelnen Lage der Leiterplatte möglich ist. Die Ausbildung der Leiterplatte als mehrlagige Leiterplatte ermöglicht dabei eine kompakte und platzsparende Bauweise für die Vorrichtung.

Das jeweilige Sensorelement kann dadurch zur kapazitiven Erfassung geeignet sein, dass es (bei entsprechender elektrischer Ansteuerung) ein elektrisches Feld bereitstellen kann, und/oder dass es gegenüber der Umgebung des Fahrzeuges und/oder in Zusammenwirkung mit einer elektrischen Masse oder Gegenelektrode des Fahrzeuges eine veränderliche Kapazität bereitstellt, die von der Umgebung abhängig ist. Die elektrische Ansteuerung des jeweiligen Sensorelements kann durch eine Verarbeitungsvorrichtung (wie einen Mikrocontroller, integrierten Schaltkreis oder dergleichen) der erfindungsgemäßen Vorrichtung erfolgen, z. B. durch wiederholte Ladungsübertragungen. Neben dem ersten und zweiten Sensorelement können auch noch weitere Sensorelemente vorgesehen sein, welche ebenfalls gemäß dem vorgenannten Prinzip betrieben werden.

Um die Detektion zu verbessern, können wenigstens zwei Abschirmelemente zur Abschirmung für die Erfassung des ersten und/oder zweiten Sensorelements vorgesehen sein. Hierbei ist insbesondere vorgesehen, dass die Abschirmelemente an unterschiedlichen Lagen der Leiterplatte angeordnet sind. Dabei kann eines der Abschirmelemente an einer ersten Lage (der unterschiedlichen Lagen der Leiterplatte) angeordnet sein und/oder an der ersten Lage das erste Sensorelement (räumlich und insbesondere überwiegend oder vollständig) umgeben, um vorzugsweise die Abschirmung in unterschiedlichen Richtungen bereitzustellen.

Die mehrlagige Ausbildung der Leiterplatte hat den weiteren Vorteil, dass die Anordnung der Abschirmelemente an mehreren Lagen erfolgen kann und somit eine dreidimensionale Anordnung der Abschirmelemente ermöglicht. Damit kann die Abschirmung besonders flexibel an einen Detektionsbereich und die Struktur für wenigstens eines der Sensorelemente angepasst werden. Die konkrete dreidimensionale Ausbildung der Abschirmelemente an der Leiterplatte ermöglicht ferner die Einstellung der Abschirmung in der Weise, dass die unterschiedlichen Richtungen festgelegt werden, in denen die Abschirmung erfolgen soll. Damit kann die Abschirmung auch dreidimensional durch die Abschirmelemente erzeugt werden, und gemäß einem besonderen Vorteil topfförmig. Damit kann die Abschirmung in besonders zuverlässiger Weise eine Beschränkung der kapazitiven Erfassung auf den Detektionsbereich bewirken. Ferner können die Abschirmelemente ggf. derart an der Leiterplatte angeordnet sein, dass eine geometrische Anpassung und insbesondere Angleichung der Abschirmung an den Detektionsbereich wenigstens eines der Sensorelemente erfolgt. Bspw. ist die geometrische Form der Abschirmung zumindest teilweise an die geometrische Form des zugehörigen Detektionsbereichs angeglichen und/oder entspricht dieser zumindest teilweise.

Die Abschirmung kann durch die Abschirmelemente für das erste Sensorelement bereitgestellt sein, optional aber auch zusätzlich für das zweite Sensorelement der erfindungsgemäßen Vorrichtung. Wenn sich die Detektionsbereiche der Sensorelemente unterscheiden, unterscheiden sich entsprechend auch die zugehörigen Abschirmungen für die unterschiedlichen Sensorelemente. Es können für jede dieser unterschiedlichen Abschirmungen eigene Abschirmelemente an der Leiterplatte vorgesehen sein. Auch kann es vorgesehen sein, dass wenigstens eines der Abschirmelemente für die Erzeugung der Abschirmung für mehr als eines der Sensorelemente dient.

Das Abschirmelement an der ersten Lage wird nachfolgend zur einfacheren Zuordnung auch als ein erstes Abschirmelement bezeichnet, wobei auch ein zweites Abschirmelement an der zweiten Lage und/oder ein drittes Abschirmelement an der dritten Lage und/oder ein viertes Abschirmelement an der vierten Lage vorgesehen sein kann. Die Abschirmelemente können lagenübergreifend elektrisch miteinander verbunden sein, und somit eine einzige Abschirmvorrichtung bilden. Das jeweilige Abschirmelement ist insbesondere in der Form einer elektrisch leitenden Fläche und/oder Leiterbahn der Leiterplatte, und die elektrische Verbindung der Abschirmelemente insbesondere als Durchkontaktierung der Leiterplatte vorgesehen.

Auch kann es möglich sein, dass das jeweilige Sensorelement in der Form einer elektrisch leitenden Fläche und/oder Leiterbahn auf der Leiterplatte vorgesehen ist. Dabei können die Sensorelemente z. B. eine Dicke im Bereich von 0,1 mm bis 0,9 mm aufweisen.

Eine mehrlagige Leiterplatte (sogenannte "Multilayer-Leiterplatte") kann ferner den Nutzen haben, dass die Packungsdichte erhöht wird, und/oder die Erzeugung elektrischer und/oder magnetischer Felder verbessert werden kann. Insbesondere wenn mehr als ein Detektionsbereich vorgesehen ist, ggf. für unterschiedliche Seiten der Vorrichtung, und/oder zusätzlich noch eine Nahfeldkommunikation durch die Vorrichtung bereitgestellt wird, kann durch den Einsatz mehrerer Lagen die Ausrichtung der Felder für die Sensorik und/oder Abschirmung und/oder für die Kommunikation vereinfacht werden. Die einzelnen Lagen der Leiterplatte können auch als (engl.) Layer bezeichnet werden. Die mehrlagige Leiterplatte kann mindestens oder genau 4 Lagen aufweisen, welche fest miteinander verbunden sind.

Die erfindungsgemäße Vorrichtung kann als eine Sensor- und/oder Kommunikationsvorrichtung ausgebildet sein. Damit ist es möglich, dass die Vorrichtung und insbesondere die Leiterplatte mehrere elektronische Komponenten aufweist, welche sowohl zur Erfassung in den Detektionsbereichen als auch zur Kommunikation, insbesondere Nahfeldkommunikation, dienen. Somit kann durch die Vorrichtung ein kompaktes und einzeln handhabbares Modul bereitgestellt werden, das mehrere Funktionen komfortabel für einen Türgriff bereitstellen kann. Die Kommunikation kann konkret eine Funk-Kommunikation bzw. eine drahtlose Kommunikation betreffen, sodass hier entsprechende Kommunikationsfelder (elektrische und/oder magnetische Felder) entstehen. Daher können sich die unterschiedlichen Felder für die Sensorerfassung und die Kommunikation auch gegenseitig stören, sodass dann zusätzliche Maßnahmen wie eine zuverlässige Abschirmung oder eine bestimmte Struktur der Sensorelemente notwendig sind.

Die erfindungsgemäße Vorrichtung kann dazu ausgeführt sein, mindestens eine der nachfolgenden Funktionen bereitzustellen:
- eine Detektion wenigstens einer Aktivierungshandlung, wie einer Annäherung und/oder Berührung und/oder Geste und/oder taktile Betätigung durch einen Benutzer, wobei die Detektion der Aktivierungshandlung im ersten oder zweiten Detektionsbereich unterschieden wird,
- eine Kommunikation, vorzugsweise Funk-Kommunikation, wie eine Nahfeldkommunikation, insbesondere mit einem mobilen Gerät wie einen ID-Geber und/oder Smartphone und/oder dergleichen, vorzugsweise zur Authentifizierung,
- eine Aktivierung wenigstens einer Fahrzeugfunktion, insbesondere einer sicherheitsrelevanten Fahrzeugfunktion wie einer Entriegelung und/oder Verriegelung, oder einer Bewegung eines beweglichen Teils des Fahrzeuges, wie einer Klappe, in Abhängigkeit von der Detektion, wobei vorzugsweise die Auswahl der aktivierten Funktion davon abhängig ist, in welchem der Detektionsbereiche die Detektion der Aktivierungshandlung erfolgt.

Die erfindungsgemäße Vorrichtung kann ferner als ein einzeln handhabbares Modul ausgeführt sein, welches als ein einziges Bauteil am Fahrzeug und/oder Fahrzeugteil montierbar ist. Hierzu kann die Vorrichtung Positionierungsmittel wie Ausnehmungen oder geometrische Anpassungen aufweisen, welche eine eindeutige Anbringung am Fahrzeug ermöglichen. Die Positionierungsmittel können gleichzeitig oder alternativ als Befestigungsmittel wie Rastelemente oder Klipse oder Klebemittel ausgebildet sein. Die Vorrichtung kann an einem Teil des Fahrzeuges wie eine Tür und/oder ein Türgriff und/oder eine Heckklappe und/oder eine Frontklappe montiert werden. Zur Montage kann bspw. die Befestigung über die Befestigungsmittel und die Positionierung mittels der Positionierungsmittel erfolgen.

Die erfindungsgemäße Vorrichtung kann vorteilhafterweise in einen Türgriff des Fahrzeuges, bevorzugt Außentürgriff des Fahrzeuges, integriert sein. Damit kann die Vorrichtung dazu ausgeführt sein, die Kommunikation und/oder die Detektion im Bereich des Türgriffs durchzuführen. Die Vorrichtung kann zur Integration in den Türgriff montiert werden, um auf diese Weise über den Türgriff am Fahrzeug montiert zu werden, insbesondere an einer Tür des Fahrzeuges.

Vorteilhaft ist es zudem, wenn das Fahrzeug als ein Kraftfahrzeug, bevorzugt Personenkraftfahrzeug, insbesondere als ein Hybridfahrzeug oder als ein Elektrofahrzeug ausgebildet ist, vorzugsweise mit einem Hochvolt-Bordnetz und/oder einem Elektromotor und/oder einer Brennkraftmaschine. Außerdem kann es möglich sein, dass das Fahrzeug als ein Brennstoffzellenfahrzeug und/oder semi-autonomes oder autonomes Fahrzeug ausgebildet ist.

Vorteilhafterweise weist das Fahrzeug ein Sicherheitssystem auf, welches z. B. durch die Kommunikation mit einem mobilen Gerät wie einem Identifikationsgeber (ID-Geber, elektronischer Schlüssel) oder Smartphone eine Authentifizierung ermöglicht. In Abhängigkeit von der Kommunikation und/oder der Authentifizierung kann (die) wenigstens eine Funktion des Fahrzeuges aktiviert werden. Falls hierzu die Authentifizierung des mobilen Geräts notwendig ist, kann es sich bei der Funktion um eine sicherheitsrelevante Funktion handeln, wie ein Entriegeln des Fahrzeuges oder eine Freigabe eines Motorstarts. Somit kann das Sicherheitssystem auch als ein passives Zugangssystem ausgebildet sein, welches ohne aktive manuelle Betätigung des mobilen Geräts die Authentifizierung und/oder die Aktivierung der Funktion bei Detektion der Annäherung des mobilen Geräts an das Fahrzeug initiiert. Hierzu wird bspw. wiederholt ein Wecksignal durch das Sicherheitssystem ausgesendet, welches durch das mobile Gerät bei der Annäherung empfangen werden kann und dann die Authentifizierung auslöst. Ebenfalls kann die Annäherung dadurch erkannt werden, dass die Aktivierungshandlung durch eine erfindungsgemäße Vorrichtung detektiert wird. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Annäherung die Fahrzeugbeleuchtung aktiviert und/oder bei der Detektion einer Geste eines Benutzers die Klappe betätigt. Das mobile Gerät kann separat vom Fahrzeug ausgeführt sein, und bspw. dazu geeignet sein, durch eine Person mit sich geführt zu werden (z. B. in einer Tasche).

Das jeweilige Sensorelement ist als kapazitiver Sensor ausgebildet, sodass die Erfassung darauf basiert, dass sich eine durch das Sensorelement bereitgestellte Kapazität verändert. Das einzelne Sensorelement kann hierbei als Elektrode aufgefasst werden, die gegenüber der Umgebung des Fahrzeuges die veränderliche Kapazität ausbildet. Hierzu muss nicht zwangsläufig eine diskrete Gegenelektrode vorgesehen sein. Es kann z. B. auch ein elektrisches Massepotential des Fahrzeuges als Gegenelektrode angesehen werden, um einen gedachten Kondensator mit der veränderlichen Kapazität auszubilden. Eine erste Aktivierungshandlung im ersten Detektionsbereich bewirkt dann eine Kapazitätsveränderung der Kapazität, welche durch das erste Sensorelement bereitgestellt wird. Eine zweite Aktivierungshandlung im zweiten Detektionsbereich bewirkt entsprechend eine Kapazitätsveränderung der Kapazität, welche durch das zweite Sensorelement bereitgestellt wird.

Das zweite Sensorelement ist zumindest teilweise deckungsgleich zum ersten Sensorelement ausgebildet. Außerdem ist das zweite Sensorelement und das erste Sensorelement (versetzt zueinander) auf unterschiedlichen Lagen der Leiterplatte angeordnet. Zusätzlich zu einer Anordnung (versetzt in axialer Richtung) auf unterschiedlichen Lagen können die Sensorelemente (in lateraler Richtung) auf (innerhalb) der jeweiligen Lage versetzt zueinander positioniert sein. Die versetzte Positionierung bezeichnet damit eine unterschiedliche Positionierung der Sensorelemente innerhalb der Ebene der jeweiligen Lage, sodass die Sensorelemente nicht überlappen. Damit sind die Sensorelemente zwar an sich deckungsgleich ausgebildet, liegen jedoch nicht deckungsgleich übereinander. Auf diese Weise kann ein Einfluss der ersten Aktivierungshandlung auf die Erfassung des zweiten Sensorelements (und/oder umgekehrt) zumindest reduziert werden.

Die Sensorelemente weisen erfindungsgemäß jeweils eine Teilstruktur auf, welche sich zumindest in einem bestimmten Mindestabstand in der lateralen Richtung x wiederholt, wobei die zueinander versetzte Positionierung der Sensorelemente in der gleichen lateralen Richtung x erfolgt. Unter "zumindest im bestimmten Mindestabstand ... wiederholen" kann dabei verstanden werden, dass die Teilstrukturen in einem festen Abstand - aber alternativ auch in unterschiedlichen Abständen - wiederholt angeordnet sein können, wobei die festen und unterschiedlichen Abstände zumindest dem Mindestabstand entsprechen. Die Teilstruktur kann sich ebenfalls in einer weiteren lateralen Richtung y wiederholen, also orthogonal zur lateralen Richtung x. Die versetzte Strukturierung der Sensorelemente ermöglicht es, dass die elektrischen Felder der Sensorelemente sich gegenseitig weniger beeinflussen können.

Es kann im Rahmen der Erfindung vorgesehen sein, dass die zueinander versetzte Positionierung der Sensorelemente mit einem bestimmten Versatz vorgesehen ist, welcher maximal der Hälfte des Mindestabstands der Teilstrukturen entspricht. Damit liegen die Sensorelemente weiterhin übereinander (in axialer Richtung), jedoch (ggf. innerhalb des Abstands oder Mindestabstands) in lateraler Richtung versetzt voneinander. In einer gedachten Draufsicht auf die Sensorelemente (in axialer Richtung) würde das eine Sensorelement das andere Sensorelement bei nicht versetzter Anordnung zumindest teilweise überdecken. Diese Überdeckung ist jedoch bei der vorgesehenen versetzten Positionierung (zumindest teilweise) aufgehoben. Bspw. weisen die Sensorelemente jeweils eine gleiche Linienstruktur auf, wobei die Linien aufgrund der versetzten Anordnung nicht überlappen.

Außerdem kann es im Rahmen der Erfindung von Vorteil sein, dass die versetzte Positionierung als eine unterschiedliche Positionierung der Sensorelemente innerhalb der jeweiligen Lage bzw. Ebene der Lage ausgeführt ist, sodass eine Überlappung der Sensorelemente verhindert ist, und insbesondere durch die Sensorelemente erzeugte elektrische Felder versetzt ausgebildet werden. Insbesondere kann hierbei die räumliche Nähe der elektrischen Felder zueinander problematisch sein, wobei die Felder in axialer Richtung übereinander ausgebildet werden können. Die in axialer Richtung vorgesehene Anordnung der Sensorelemente bzw. der zugehörigen Teilstrukturen übereinander kann dabei ggf. durch die Anordnung der Detektionsbereiche vorgegeben sein. Die Erfindung geht dabei von der Überlegung aus, dass zwar die übereinander vorgesehene Anordnung nicht verhindert werden kann, eine versetzte Anordnung der Teilstrukturen die gegenseitige Beeinflussung der Felder jedoch reduzieren kann.

Auch ist es optional denkbar, dass die deckungsgleichen Bereiche der Sensorelemente gleich ausgebildete Teilstrukturen aufweisen, insbesondere in der Form einer Linienstruktur. Die deckungsgleichen Bereiche können somit die ebenfalls deckungsgleich ausgebildeten Teilstrukturen aufweisen, die bspw. in der Art einer Linienstruktur wiederholt angeordnet sind. Eine derartige Teilstruktur kann den Vorteil haben, dass eine elektromagnetische Wechselwirkung wie eine Induktion von Wirbelströmen reduziert wird.

Es ist ferner denkbar, dass hinsichtlich der lateralen Richtung (d. h. insbesondere auf einer gemeinsamen Projektionsebene bei einer orthogonalen Parallelprojektion der jeweiligen Lagen in die axiale Richtung als Projektionsrichtung) die Teilstrukturen, insbesondere die Linien, des zweiten Sensorelements zwischen den Teilstrukturen, insbesondere den Linien, des ersten Sensorelements angeordnet sind. In anderen Worten wird die versetzte Positionierung dadurch erreicht, dass die Teilstrukturen versetzt zueinander angeordnet werden. Auf diese Weise kann zuverlässig eine Beeinflussung der Teilstrukturen des ersten Sensorelements auf die Teilstrukturen des zweiten Sensorelements verringert werden. Eine Überlappung der Teilstrukturen findet somit nicht statt.

Unter einer Linienstruktur kann konkret eine geometrische Struktur verstanden werden, bei welcher mehrere Zweige (die Linien) parallel nebeneinander angeordnet sind. Die Zweige können (nur) über eine gemeinsame Leiterbahn miteinander verbunden sein. Dabei können die Zweige von der Leiterbahn senkrecht abgehen, ggf. auch in unterschiedliche Richtungen. Die Linien können als Teilstruktur in einem bestimmten Abstand oder Mindestabstand zueinander nebeneinander angeordnet sein.

Gemäß einem weiteren Vorteil kann vorgesehen sein, dass das zweite Sensorelement eine längere Erstreckung aufweist als das erste Sensorelement, sodass der zweite Detektionsbereich größer als der erste Detektionsbereich ausgeführt ist. Dies ermöglicht es z. B., dass für die Aktivierungshandlung im zweiten Detektionsbereich ein größerer räumlicher Bereich zur Verfügung steht, insbesondere in einer Türgriffmulde.

In einer weiteren Möglichkeit kann vorgesehen sein, dass ein Abschirmelement an einer zweiten Lage der Leiterplatte vorgesehen ist, und zumindest teilweise eine deckungsgleiche Ausbildung zum ersten Sensorelement an einer ersten Lage der Leiterplatte und/oder zumindest teilweise zum zweiten Sensorelement an einer weiteren, insbesondere vierten, Lage der Leiterplatte aufweist, und vorzugsweise in der lateralen Richtung positionsgleich zum ersten Sensorelement sowie versetzt zum zweiten Sensorelement positioniert ist. In anderen Worten können bei einer Draufsicht (in axialer Richtung) das erste Sensorelement an der ersten Lage und das Abschirmelement an der zweiten Lage (zumindest teilweise oder überwiegend oder vollständig) überlappen. Das Abschirmelement an der zweiten Lage kann dabei auch positionsgleich zum ersten Sensorelement an der ersten Lage angeordnet sein, also nicht versetzt, sodass insbesondere bei der Draufsicht das Abschirmelement vollständig das erste Sensorelement abdeckt. Entsprechend kann auch das Abschirmelement an der zweiten Lage mit der gleichen geometrischen Ausbildung, insbesondere Teil- und vorzugsweise Linienstruktur, des ersten Sensorelements ausgeführt sein. Dieses Abschirmelement erzeugt dann eine Abschirmung, die einen störenden Einfluss der elektrischen Masse an der zweiten Lage reduziert.

In einer weiteren Möglichkeit kann vorgesehen sein, dass eine elektrische Masse sich flächig an der zweiten Lage benachbart zum Abschirmelement an der zweiten Lage erstreckt, insbesondere parallel und/oder gegenüber zu einem Bereich zur Anordnung von Elektronikbauteilen an der ersten Lage und/oder zu einem der Abschirmelemente an einer dritten Lage. Alternativ oder zusätzlich kann die Masse sich zwar als Leiterfläche (entsprechend flächig) über die zweite Lage erstrecken, aber in einem Bereich gegenüber des Sensorelements an der ersten Lage eine Aussparung aufweisen. In dieser Aussparung kann z. B. das (zweite) Abschirmelement an der zweiten Lage angeordnet sein. Dagegen kann der Bereich der Masse gegenüber dem Bereich zur Anordnung von Elektronikbauteilen durchgängig ausgebildet sein.

Des Weiteren ist es denkbar, dass eine Verarbeitungsvorrichtung an der Leiterplatte angeordnet ist, und elektrisch für Ladungsübertragungen mit den Sensorelementen verbunden ist, um anhand der Ladungsübertragungen eine veränderliche elektrische Kapazität des jeweiligen Sensorelements auszuwerten und hierdurch die jeweilige kapazitive Erfassung bereitzustellen. In anderen Worten kann die kapazitive Erfassung und/oder Detektion dadurch erfolgen, dass durch die Verarbeitungsvorrichtung die veränderliche Kapazität ermittelt wird. Die veränderliche elektrische Kapazität wird insbesondere durch das jeweilige Sensorelement bereitgestellt und ist für eine Veränderung im Detektionsbereich spezifisch. Somit kann diese kapazitive Erfassung zur Detektion der Aktivierungshandlung führen. Es ist auch möglich, dass die Verarbeitungsvorrichtung die Abschirmelemente ansteuert, z. B. ebenfalls durch Ladungsübertragungen.

In einer weiteren Möglichkeit kann vorgesehen sein, dass die Verarbeitungsvorrichtung dazu ausgeführt ist, die Detektion der Aktivierungshandlung derart durchzuführen, dass eine Annäherung und/oder eine Geste eines Benutzers anhand der Auswertung der jeweiligen Kapazität detektiert wird, und zwischen einer ersten Aktivierungshandlung im ersten Detektionsbereich und einer zweiten Aktivierungshandlung im zweiten Detektionsbereich unterschieden wird. Hierzu kann die Verarbeitungsvorrichtung z. B. eine Veränderung der jeweiligen Kapazität auswerten, z. B. einen Vergleich mit einem Schwellenwert durchführen. Wenn bei einem der Sensorelemente der Schwellenwert durch die veränderte Kapazität überschritten wird, kann die Aktivierungshandlung im Detektionsbereich dieses Sensorelements detektiert werden. Bspw. kann die Fahrzeugfunktion dann aktiviert werden, insbesondere durch eine elektrische Signalausgabe der Vorrichtung, wenn die Detektion positiv erfolgt ist, also bspw. die Annäherung und/oder Berührung und/oder Betätigung und/oder Geste detektiert wurde. Je nachdem, in welchem der Detektionsbereiche die Aktivierungshandlung erkannt wurde, können unterschiedliche elektrische Signale ausgegeben werden, und somit auch unterschiedliche Fahrzeugfunktionen aktiviert werden.

Von weiterem Vorteil kann vorgesehen sein, dass eine (elektronische) Verarbeitungsvorrichtung elektrisch mit den Abschirmelementen verbunden ist, um die (oder wenigstens eines der) Abschirmelemente zur Bereitstellung einer aktiven Abschirmung ("Active Shield") zu betreiben, bei welcher ein elektrisches Potential der (oder des) Abschirmelemente(s) in Abhängigkeit von einem elektrischen Potential wenigstens eines der Sensorelemente eingestellt wird. In anderen Worten wird das elektrische Potential der Abschirmelemente dem Potential des Sensorelements nachgeführt.

Auch ist es optional denkbar, dass ein Kommunikationsmittel auf den Lagen der Leiterplatte angeordnet ist, und vorzugsweise sich über mindestens 2 oder mindestens 4 oder sämtliche der Lagen und/oder (lateral) beabstandet zum Sensor- und/oder Abschirmelement erstreckt, um eine Nahfeldkommunikation mit einem mobilen Gerät bereitzustellen. Die Nahfeldkommunikation kann dabei mit dem mobilen Gerät außerhalb des Fahrzeuges bereitgestellt werden. In diesem Falle kann das Fahrzeugteil als Außentürgriff ausgeführt sein. So ist das mobile Gerät bspw. als Smartphone ausgebildet, welches dann zur Authentifizierung lediglich an die Vorrichtung bzw. den Außentürgriff gehalten werden muss, um die Nahfeldkommunikation zu ermöglichen. Alternativ kann der Türgriff auch als Innentürgriff ausgeführt sein, sodass die Nahfeldkommunikation im Innenraum des Fahrzeuges durchgeführt wird.

Das Kommunikationsmittel ist vorteilhafterweise geeignet, eine Nahfeldkommunikation wie NFC (engl. near field communication) oder RFID (engl. radio-frequency identification) bereitzustellen bzw. durchzuführen. Das Kommunikationsmittel ist z. B. als eine Antenne, insbesondere NFC-Antenne, ausgebildet, welche zumindest teilweise an einigen oder sämtlichen der Lagen der Leiterplatte vorgesehen sein kann. Die Teile des Kommunikationsmittels auf den unterschiedlichen Lagen können dabei mittels Durchkontaktierungen miteinander elektrisch verbunden sein, um insgesamt eine Schleife (z. B. NFC-Loop) auf mehreren Layern bereitzustellen. Das Kommunikationsmittel ermöglicht somit, dass die erfindungsgemäße Vorrichtung neben der Sensor-Funktion auch noch eine Kommunikationsfunktion bereitstellt. Das Kommunikationsmittel kann als Leiterbahn ausgeführt sein, und insbesondere einen gleichbleibenden Abstand zu einer elektrischen Massefläche und/oder zu den Sensor- und/oder Abschirmelementen der Leiterplatte (in lateraler Richtung) aufweisen. Dabei kann das Kommunikationsmittel am äußeren Rand der Leiterplatte bzw. Lage verlaufen.

Es kann vorgesehen sein, dass das Kommunikationsmittel dazu dient, insbesondere ausgelöst durch eine (erfolgreiche) Detektion einer Aktivierungshandlung, die Authentifizierung über die Nahfeldkommunikation durchzuführen. Bspw. erkennt hierbei eine Verarbeitungsvorrichtung und/oder ein Steuergerät des Fahrzeuges, dass die Detektion erfolgreich war, und löst die Authentifizierung über das Kommunikationsmittel aus. Damit kann abhängig von der Authentifizierung die Funktion des Fahrzeuges, insbesondere eine Entriegelung und/oder Verriegelung des Fahrzeuges, aktiviert werden. Bspw. führt ein Benutzer das mobile Gerät mit sich, wenn dieser die Aktivierungshandlung durchführt. Durch die Aktivierungshandlung macht der Benutzer deutlich, dass dieser die Funktion des Fahrzeuges aktivieren möchte. Es kann sich allerdings bei der Funktion um eine sicherheitsrelevante Funktion handeln, welche die Authentifizierung des Benutzers über das mobile Gerät erfordert. Die Detektion der Aktivierungshandlung durch die erfindungsgemäße Vorrichtung kann aus diesem Grunde den Authentifizierungsvorgang auslösen, welcher dann ebenfalls durch die Vorrichtung mittels der Kommunikation insbesondere Nahfeldkommunikation bereitgestellt wird. Die Verarbeitungsvorrichtung und/oder das Steuergerät des Fahrzeuges können dann auch die erfolgreiche Authentifizierung erkennen und nur dann die Funktion des Fahrzeuges aktivieren. Zur Kommunikation kann durch die Verarbeitungsvorrichtung und/oder das Steuergerät des Fahrzeuges eine Verarbeitungsanordnung der Vorrichtung wie ein NFC-Schaltkreis angesteuert werden.

Es kann vorgesehen sein, dass eine Verarbeitungsanordnung und/oder eine Verarbeitungsvorrichtung bei der erfindungsgemäßen Vorrichtung vorgesehen sind, welche einzeln oder zusammen zur Auswertung der Erfassung und/oder zur Detektion der Aktivierungshandlung und/oder zum Empfangen- und/oder Senden bei der Kommunikation - insbesondere Nahfeldkommunikation - dienen. Die Verarbeitungsanordnung und die Verarbeitungsvorrichtung können dabei als separate Mikrocontroller bzw. integrierte Schaltkreise (IC) ausgebildet sein. Zum Beispiel kann die Verarbeitungsvorrichtung dediziert zur Detektion und die Verarbeitungsanordnung zur Nahfeldkommunikation genutzt werden. Auch ist es möglich, dass die Verarbeitungsanordnung und die Verarbeitungsvorrichtung gemeinsam als ein IC ausgebildet sind. Ebenfalls ist es eine Möglichkeit, dass die Verarbeitungsanordnung Teil der Verarbeitungsvorrichtung ist, z. B. eines Mikrocontrollers bzw. ICs. Die Verarbeitungsanordnung und/oder die Verarbeitungsvorrichtung können dabei eine Schnittstelle zur weiteren Fahrzeugelektronik, insbesondere eines Steuergeräts, aufweisen. Bspw. kann durch die Verarbeitungsvorrichtung ein Signal an die Fahrzeugelektronik ausgegeben werden, welches indiziert, dass erfolgreich die Detektion stattgefunden hat. Das Empfangen dieses Signals kann wiederum die Authentifizierung auslösen, welche die Fahrzeugelektronik dann über eine weitere Schnittstelle mit der Verarbeitungsanordnung einleitet.

Vorteilhaft ist es darüber hinaus, wenn im Rahmen der Erfindung das erste Sensorelement an einer ersten Lage angrenzend zum ersten Detektionsbereich ausgebildet ist, und das zweite Sensorelement an einer weiteren, insbesondere vierten, Lage angrenzend zum zweiten Detektionsbereich ausgebildet ist, wobei vorzugsweise die jeweiligen Lagen als äußere Lagen der Leiterplatte vorgesehen sind, um insbesondere die Detektionsbereiche durch die Sensorelemente auf unterschiedlichen Seiten eines Türgriffs des Fahrzeuges über die jeweilige veränderliche elektrische Kapazität der Sensorelemente auszubilden, sodass anhand der Kapazitäten eine erste Aktivierungshandlung im ersten Detektionsbereich von einer zweiten Aktivierungshandlung im zweiten Detektionsbereich unterschieden wird, um gemäß der Unterscheidung unterschiedliche Funktionen des Fahrzeuges zu aktivieren. Diese Unterscheidung kann bspw. durch eine Verarbeitungsvorrichtung durchgeführt werden, indem die Veränderungen der jeweiligen Kapazitäten bewertet werden.

Von weiterem Vorteil kann vorgesehen sein, dass ein Kommunikationsmittel auf den Lagen der Leiterplatte angeordnet ist, und vorzugsweise sich über sämtliche der Lagen beabstandet zu den Sensorelementen sich erstreckt, um eine Nahfeldkommunikation mit einem mobilen Gerät außerhalb des Fahrzeuges bereitzustellen, und vorzugsweise um ausgelöst durch die (jeweilige) Detektion der Aktivierungshandlung eine Authentifizierung über die Nahfeldkommunikation durchzuführen, und um bevorzugt abhängig von der Authentifizierung die wenigstens eine Funktion des Fahrzeuges, insbesondere eine Entriegelung und/oder Verriegelung des Fahrzeuges, zu aktivieren. Die beabstandete Anordnung des Kommunikationsmittels zu den Sensorelementen kann dabei in lateraler Richtung mit einem festen Abstand vorgesehen sein.

Auch ist es optional denkbar, dass die versetzte Positionierung der Sensorelemente derart als eine unterschiedliche Positionierung der Sensorelemente in der lateralen Richtung ausgeführt ist, dass eine Störung durch die kapazitive Erfassung des ersten Sensorelements im ersten Detektionsbereich auf die kapazitive Erfassung des zweiten Sensorelements im zweiten Detektionsbereich reduziert wird. Entsprechend kann die Positionierung, d. h. bspw. der Versatz der Sensorelemente in lateraler Richtung zueinander, so gewählt werden, dass die Störung reduziert wird. Hierzu kann z. B. ein Versuchsaufbau der erfindungsgemäßen Vorrichtung genutzt werden, bei welchem der Versatz sukzessive erhöht wird, während gleichzeitig die elektrischen Felder durch die Sensorelemente erzeugt werden. Ein Grad der Störung ist dabei z. B. durch die Messung der veränderlichen Kapazitäten feststellbar, welche durch die Sensorelemente gebildet werden. Bspw. kann die Störung in der Art einer Veränderung der zweiten Kapazität des zweiten Sensorelements gemessen werden, wenn nur im ersten Detektionsbereich des ersten Sensorelements eine Aktivierungshandlung durchgeführt wird. Es kann dann ein Versatz für die Positionierung gewählt werden, bei welchem die Störung minimal ist.

Es ist ferner denkbar, dass der jeweilige deckungsgleiche Bereich der Sensorelemente eine sich wiederholende Teilstruktur aufweist, welche dazu ausgebildet ist, ein elektrisches Feld zur jeweiligen kapazitiven Erfassung auszubilden, und vorzugsweise derart ausgerichtet und/oder angeordnet ist, dass eine störende Wechselwirkung zu einem Kommunikationsmittel der Leiterplatte verringert wird. Das Kommunikationsmittel ist bspw. dazu ausgeführt, eine Nahfeldkommunikation mittels magnetischer Felder zu erzeugen. Somit kann das Kommunikationsmittel im Betrieb grundsätzlich einen elektrischen Wirbelstrom in den Sensorelementen induzieren. Die Teilstruktur kann z. B. als Linienstruktur dazu ausgeführt sein, diese Induktion von Wirbelströmen zumindest zu reduzieren. Die Anordnung und/oder Ausrichtung der Teilstrukturen kann dann in einer Weise erfolgen, dass eine Abschwächung des durch das Kommunikationsmittel bereitgestellten Kommunikationsfeldes reduziert oder minimiert wird. Hierzu kann z. B. die Ausrichtung und/oder Anordnung verändert werden, und gleichzeitig das Kommunikationsfeld gemessen oder simuliert werden.

Ebenfalls Gegenstand der Erfindung ist ein Türgriff für ein Fahrzeug, wobei der Türgriff als das Fahrzeugteil eine erfindungsgemäße Vorrichtung aufweist. Damit bringt der erfindungsgemäße Türgriff die gleichen Vorteile mit sich, wie sie ausführlich mit Bezug auf eine erfindungsgemäße Vorrichtung beschrieben worden sind.

Ebenfalls unter Schutz gestellt sein kann ein Verfahren zur Herstellung einer erfindungsgemäßen Vorrichtung und/oder ein Verfahren zum Betreiben einer erfindungsgemäßen Vorrichtung.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Seitenansicht eines Fahrzeuges mit einer erfindungsgemäßen Vorrichtung,
- Fig. 2: eine schematische seitliche Schnittansicht eines Türgriffs mit einer erfindungsgemäßen Vorrichtung des Fahrzeuges in Fig. 1, welche perspektivisch einer Draufsicht auf das Fahrzeug entspricht,
- Fig. 3: eine vergrößerte Seitendarstellung der erfindungsgemäßen Vorrichtung in Fig. 2,
- Fig. 4-7: schematische Schnittansichten verschiedener Lagen der erfindungsgemäßen Vorrichtung in Fig. 2 und 3,
- Fig. 8: ein schematisches Schaltbild von Teilen einer erfindungsgemäßen Vorrichtung.

In den nachfolgenden Figuren werden für die gleichen technischen Merkmale auch von unterschiedlichen Ausführungsbeispielen die identischen Bezugszeichen verwendet.

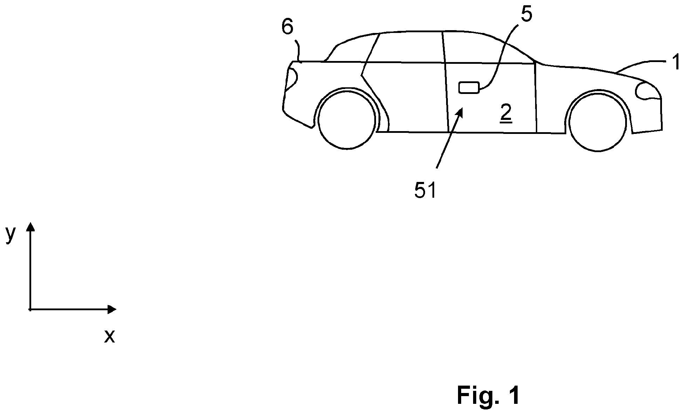

In Figur 1 ist ein Fahrzeug 1 mit einem erfindungsgemäßen Türgriff 5 gezeigt. Der Türgriff 5 kann hierbei ein Fahrzeugteil 5 bilden, welches eine erfindungsgemäße Vorrichtung 10 aufweist.

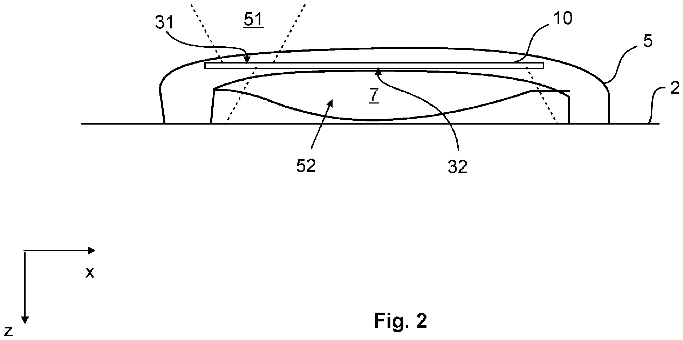

Der Türgriff 5 ist an einer Tür 2 des Fahrzeuges 1 befestigt, um die Tür 2 durch einen manuellen Öffnungsvorgang zu öffnen. Hierzu kann ein Benutzer in eine in Figur 2 gezeigte Türgriffmulde 7 eingreifen, und an dem Türgriff 5 ziehen. Für den Öffnungsvorgang ist es erforderlich, dass ein Schloss der Tür 2 entriegelt wird. Hierzu kann das Eingreifen in die Türgriffmulde 7 als Aktivierungshandlung detektiert werden, um eine Authentifizierung und - bei erfolgreicher Authentifizierung - die Entriegelung als Funktion des Fahrzeuges 1 zu aktivieren. Eine Verriegelung kann als eine weitere Funktion des Fahrzeuges 1 aktiviert werden, wenn die Annäherung in einen Detektionsbereich 51 als Aktivierungshandlung detektiert wird. Dabei handelt es sich selbstverständlich nur um Beispiele für Funktionen und Aktivierungshandlungen. Bei einem flächenbündigen Türgriff 5 kann die Funktion des Fahrzeuges 1 z. B. der Öffnungsvorgang selbst sein, welcher automatisiert durchgeführt wird. Auch ist es denkbar, dass eine erfindungsgemäße Vorrichtung 10 im Heck- oder Frontbereich angeordnet ist, sodass die Funktion der Öffnungsvorgang einer Klappe 6 des Fahrzeuges 1 ist.

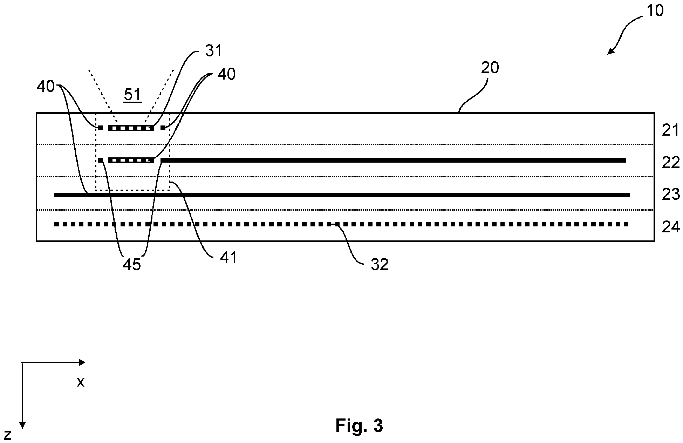

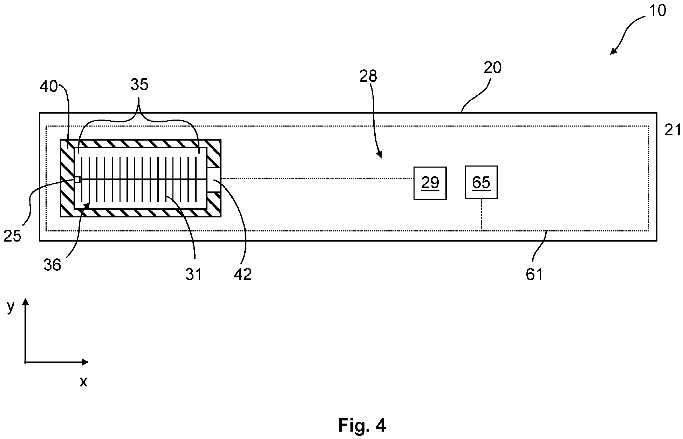

In Figur 1 ist die Seitenansicht des Fahrzeuges 1 gezeigt, wobei die zueinander orthogonalen Richtungen x und y angegeben sind. In Figur 2 wird perspektivisch eine Draufsicht auf das Fahrzeug 1 entsprechend den angegebenen zueinander orthogonalen Richtungen x und z verwendet. Die Darstellung in Figur 2 (und auch in Figur 3) entspricht perspektivisch einer Seitenansicht auf den Türgriff 5 bzw. auf die erfindungsgemäße Vorrichtung 10 und die Lagen 21, 22, ,23, 24. In den Figuren 4 bis 7 werden dagegen Schnittansichten der Vorrichtung 10 dargestellt, die perspektivisch aus einer Draufsicht auf die Vorrichtung 10 resultieren, und somit wieder der Seitenansicht des Fahrzeuges 1 in Figur 1 entsprechen. Die im Rahmen dieser Erfindung diskutierten geometrischen Zusammenhänge (z. B. die deckungsgleiche Ausbildung und die Positionierung der Abschirm- und Sensorelemente 40, 31 sowie der Massefläche 45 verschiedener Lagen 21, 22 ,23 ,24) können dabei in Bezug auf diese gedachte Draufsicht auf die erfindungsgemäße Vorrichtung 10 beschrieben sein. Diese Draufsicht kann definiert sein als eine Sicht in die axiale Richtung z, welche orthogonal zur längsten Erstreckung der Lagen 21, 22 ,23 ,24 bzw. zu den lateralen Richtungen x und y ist.

Wie in Figur 2 dargestellt ist, weist der Türgriff 5 die erfindungsgemäße Vorrichtung 10 auf, welche zur Detektion einer Aktivierungshandlung in einem Detektionsbereich 51, und insbesondere über den Türgriff 5 zur Montage an der Tür 5, dient. Durch die Vorrichtung 10 kann eine Funktion des Fahrzeuges 1 in Abhängigkeit von der Detektion zu aktiviert werden.

Die Vorrichtung 10 kann eine in Figur 3 mit weiteren Einzelheiten gezeigte mehrlagige Leiterplatte 20 aufweisen, an der wenigstens ein elektrisch leitendes Sensorelement 31 zur kapazitiven Erfassung im Detektionsbereich 51 an einer ersten Lage 21 der Leiterplatte 20 angeordnet ist. Der Detektionsbereich 51 kann als ein erster Detektionsbereich 51 ausgeführt sein, welcher sich außerhalb des Fahrzeuges 1 im Bereich einer ersten Außenseite des Türgriffs 5 erstreckt. Ebenfalls kann ein zweiter Detektionsbereich 52 sich im Bereich der Türgriffmulde 7 bzw. einer zweiten Außenseite des Türgriffs 5 erstrecken. Die zweite Außenseite kann dabei der Türgriffmulde 7 zugewandt und die erste Außenseite der Türgriffmulde 7 abgewandt sein (siehe Figur 2). Es kann somit möglich sein, dass das Sensorelement 31 - als ein erstes Sensorelement 31 - zur kapazitiven Erfassung in dem Detektionsbereich 51 - als einen ersten Detektionsbereich 51 - an der Leiterplatte 20 vorgesehen ist. Es kann ferner auch ein zweites Sensorelement 32 der Vorrichtung 10 an einer vierten Lage 24 vorgesehen sein, welches im zweiten Detektionsbereich 52 ebenfalls eine kapazitive Erfassung durchführt. Dies ermöglicht die Detektion unterschiedlicher Aktivierungshandlungen. Das jeweilige Sensorelement 31, 32 kann als kapazitiver Sensor ausgebildet sein, sodass die Erfassung darauf basiert, dass sich eine durch das jeweilige Sensorelement 31, 32 bereitgestellte Kapazität verändert. Das einzelne Sensorelement 31, 32 kann hierbei als Elektrode aufgefasst werden, die gegenüber der Umgebung des Fahrzeuges 1 die veränderliche Kapazität ausbildet. Es kann hierzu ein elektrisches Massepotential des Fahrzeuges 1 als Gegenelektrode angesehen werden, um einen gedachten Kondensator mit der veränderlichen Kapazität auszubilden. Eine erste Aktivierungshandlung im ersten Detektionsbereich 51 bewirkt dann eine Kapazitätsveränderung der Kapazität, welche durch das erste Sensorelement 31 bereitgestellt wird. Eine zweite Aktivierungshandlung im zweiten Detektionsbereich 52 bewirkt entsprechend eine Kapazitätsveränderung der Kapazität, welche durch das zweite Sensorelement 32 bereitgestellt wird.

Um die Detektion zu verbessern, können - wie in Figur 3 gezeigt ist - wenigstens zwei Abschirmelemente 40 zur Abschirmung 41 für die Erfassung dienen. Die Abschirmelemente 40 sind hierbei an unterschiedlichen Lagen 21, 22, 23, 24 der Leiterplatte 20 angeordnet, wobei eines der Abschirmelemente 40 an einer ersten Lage 21 das (erste) Sensorelement 31 umgibt, um die Abschirmung 41 in unterschiedlichen Richtungen x, y, z bereitzustellen. Dargestellt ist in Figur 3 eine "Topfform" der Abschirmung 41, die durch die gezeigte Anordnung der Abschirmelemente 40 erzeugt werden kann. Die Abschirmelemente 40 können dabei derart an den Lagen 21, 22, 23, 24 verteilt angeordnet sein, dass die Abschirmung 41 den Detektionsbereich 51 in den drei zueinander orthogonalen Richtungen x, y, z begrenzt, und in einer (in Figur 4 gezeigten) Ebene x-y den Detektionsbereich 51 überwiegend oder vollständig umgibt.

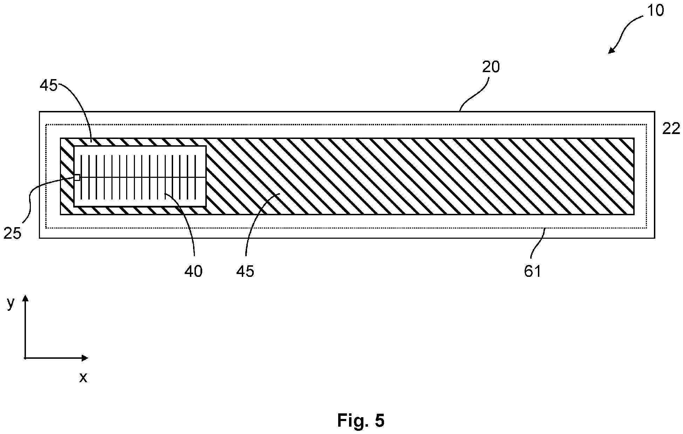

Wie in Figur 4 gezeigt ist, kann das Abschirmelement 40 an der ersten Lage 21 das Sensorelement 31 überwiegend, und ggf. sogar vollständig (nicht gezeigt), umgeben. In Figur 4 ist konkret gezeigt, dass das Sensorelement 31 nur überwiegend, also teilweise, durch das Abschirmelement 40 umgeben ist. Hierzu weist das Abschirmelement 40 eine Unterbrechung 42 auf, um ein Auftreten von Kurzschlussströmen insbesondere durch eine Wechselwirkung mit dem Kommunikationsmittel 61 beim Betrieb zur Kommunikation, insbesondere NFC-Kommunikation, zu vermeiden. Die Unterbrechung 42 kann elektrisch isoliert ausgeführt sein, um insbesondere derartige Störungen bei der Kommunikation zu vermeiden. Damit ist gewährleistet, dass ein durch das Sensorelement 31 erzeugtes elektrisches Feld zuverlässig in den Detektionsbereich 51 gerichtet wird. Um die Erfassung im Detektionsbereich 51 weiter zu verbessern, kann gemäß Figur 5 eines der Abschirmelemente 40 an einer zweiten Lage 22 deckungsgleich zum Sensorelement 31 an der ersten Lage 21 ausgebildet sein. Das Abschirmelement 40 an der zweiten Lage 22 kann entsprechend zumindest teilweise deckungsgleich und positionsgleich zum Sensorelement 31 an der ersten Lage angeordnet sein. Positionsgleich bezieht sich hierbei selbstverständlich nur auf die Richtungen x und y. Bei einer gedachten Draufsicht auf die Lage 22 in Figur 5 und die darunter befindliche Lage 21 könnte somit bei einer teilweise transparenten Lagen 21, 22 das Sensorelement 31 hinter dem Abschirmelement 40 an der zweiten Lage 22 nicht mehr sichtbar sein, zumindest für den Teil, für den das Abschirmelement 40 deckungsgleich vorgesehen ist.

Gemäß Figur 5 kann sich ferner eine elektrische Masse 45 flächig an der zweiten Lage 22 benachbart zum Abschirmelement 40 an der zweiten Lage 22 erstrecken, insbesondere parallel zu einem Bereich 28 zur Anordnung von Elektronikbauteilen an der ersten Lage 21 und/oder zu einem der Abschirmelemente 40 an einer dritten Lage 23. Diese Massefläche 45 kann eine Aussparung für das Sensorelement 31 an der ersten bzw. für das korrespondierende Abschirmelement 40 an der zweiten Lage 22 aufweisen. Darüber hinaus kann die Masse 45 zur Entstörung der elektronischen Bauteile im Bereich 28 der ersten Lage 21 dienen. Ferner kann der Bereich der Masse 45 um die Aussparung herum deckungs- und/oder positionsgleich zum Abschirmelement 40 an der ersten Lage 21 ausgebildet sein.

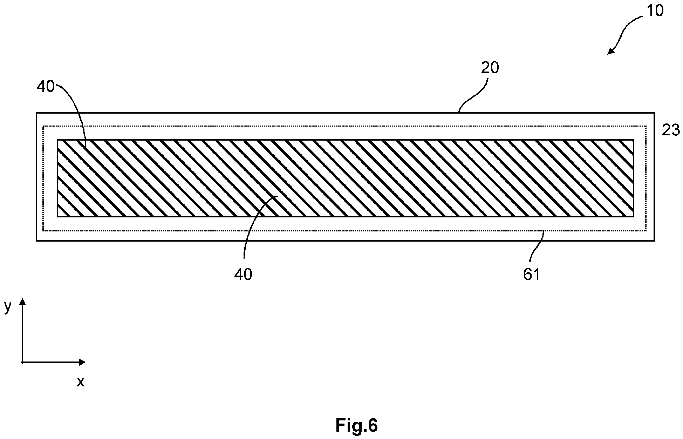

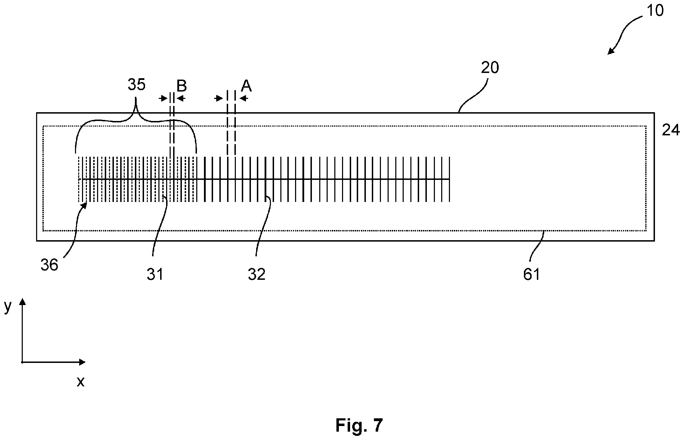

In Figur 6 ist dargestellt, dass eines der Abschirmelemente 40 an einer dritten Lage 23 sich flächig und einseitig zum Sensorelement 31 an der ersten Lage 21 erstreckt, um die Abschirmung 41 einseitig bereitzustellen. Darüber hinaus erstreckt sich dieses dargestellte Abschirmelement 40 noch weiter in Richtung x, um hier gleichzeitig die Abschirmung 41 für das zweite Sensorelement 32 in Figur 7 bereitzustellen. Das Abschirmelement 40 und das zweite Sensorelement 32 weisen somit eine längere Erstreckung auf als das erste Sensorelement 31.

In Figur 7 ist das Sensorelement 31 der ersten Lage 21 gestrichelt dargestellt, um die Position des Sensorelements 31 unterhalb der vierten Lage 24 zu verdeutlichen. Um einen Einfluss der ersten Aktivierungshandlung auf die Erfassung des zweiten Sensorelements 32 zumindest zu reduzieren, kann es vorgesehen sein, dass die Sensorelemente 31, 32 wie in Figur 7 dargestellt zwar zumindest teilweise deckungsgleich zueinander ausgebildet, jedoch versetzt zueinander positioniert sind. In anderen Worten ist neben der versetzten Anordnung auf den unterschiedlichen Lagen 21, 24 der Leiterplatte 20 (in axialer Richtung z) zusätzlich eine versetzte Positionierung der Sensorelemente 31, 32 zueinander innerhalb der jeweiligen Lage 21, 24 (in Richtung x) vorgesehen. Damit ist das zweite Sensorelement 32 zwar zumindest teilweise deckungsgleich zum ersten Sensorelement 31 ausgebildet, jedoch nicht deckungsgleich (oder positionsgleich) angeordnet. In einer gedachten Draufsicht auf die Sensorelemente 31, 32 in axialer Richtung z würde das erste Sensorelement 31 das zweite Sensorelement 32 bei nicht versetzter Positionierung zumindest für einen Teilabschnitt überdecken. Diese Überdeckung ist jedoch bei der vorgesehenen versetzten Positionierung (zumindest teilweise) aufgehoben. Diese versetzte Positionierung kann auch so verstanden werden, dass die deckungsgleichen Bereiche 35 der Sensorelemente 31, 32 in der lateralen Richtung x zueinander versetzt positioniert sind. Wie in Figur 7 durch die gestrichelte Linie dargestellt ist, ist das erste Sensorelement 31 versetzt um den Versatz B zum zweiten Sensorelement 32 angeordnet und daher nicht überdeckt. Konkret weisen in der Darstellung die Sensorelemente 31, 32 jeweils eine gleiche Linienstruktur auf, wobei die Linien aufgrund der versetzten Positionierung nicht überlappen. Die Linien sind dabei als Teilstrukturen 36 der Sensorelemente 31, 32 im Abstand A voneinander angeordnet. Der Versatz B beträgt etwa oder genau die Hälfte des Abstands A.

Es ist in den gezeigten Beispielen vorgesehen, dass die Abschirmelemente 40 an den unterschiedlichen Lagen 21, 22, 23, 24 über Durchkontaktierungen 25 miteinander verbunden sind, und somit potentialgleich vorgesehen sind. Alternativ können die Abschirmelemente 40 an den unterschiedlichen Lagen 21, 22, 23, 24 auch elektrisch voneinander getrennt ausgebildet sein, um unterschiedliche elektrische Potentiale aufzuweisen. Auch ist eine Mischung aus getrennten und verbundenen Abschirmelementen 40 denkbar. Die Verbindung über Durchkontaktierungen 25 hat indessen den Vorteil, dass nur eine elektrische Verbindung der Abschirmelemente 40 mit einer Verarbeitungsvorrichtung 29 notwendig ist, um die Abschirmelemente 40 zur Bereitstellung einer aktiven Abschirmung 41 zu betreiben, bei welcher ein elektrisches Potential der Abschirmelemente 40 in Abhängigkeit von einem elektrischen Potential des Sensorelements 31 und/oder 32 eingestellt wird. Die Verarbeitungsvorrichtung 29 und/oder eine Verarbeitungsanordnung 65 für eine Nahfeldkommunikation können dabei in einem Bereich 28, insbesondere an der ersten Lage 21 gemäß Figur 4, angeordnet sein. Dieser Bereich kann sich gegenüber einer Massefläche 45, insbesondere an der zweiten Lage 22, erstrecken.

Weiter ist in den Figuren 4 bis 7 gezeigt, dass ein Kommunikationsmittel 61 auf den Lagen 21, 22, 23, 24 der Leiterplatte 20 angeordnet sein kann, und vorzugsweise sich über sämtliche der Lagen 21, 22, 23, 24 beabstandet zum Sensor- und Abschirmelement 31, 40 erstreckt. Das Kommunikationsmittel 61 ist hierbei nicht mit seiner konkreten Ausbildung auf den jeweiligen Lagen 21, 22, 23, 24 dargestellt, sondern nur schematisch über eine gestrichelte Linie. Dabei kann das Kommunikationsmittel 61 entlang dieser Linie ausgebildet sein, jedoch auf unterschiedlichen Lagen 21, 22, 23, 24. In anderen Worten kann das Kommunikationsmittel 61 auf einer der Lagen 21, 22, 23, 24 unterbrochen sein und über eine Durchkontaktierung 25 an dieser lateralen Position aber auf einer anderen Lage 21, 22, 23, 24 wieder als Leiterbahn fortgesetzt werden. Das Kommunikationsmittel 61 kann als Nahfeldantenne ausgeführt sein, um eine Nahfeldkommunikation mit einem mobilen Gerät außerhalb des Fahrzeuges 1 bereitzustellen. Diese Nahfeldkommunikation kann ausgelöst durch die Detektion der Aktivierungshandlung zur Durchführung einer Authentifizierung dienen.

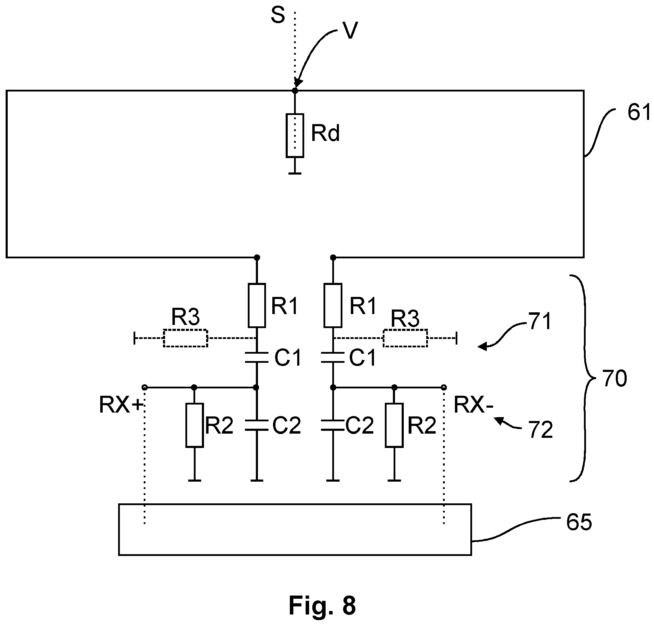

In Figur 8 ist eine beispielhafte Ausbildung für ein Kommunikationsmittel 61, insbesondere einer NFC-Antenne, zur Nahfeldkommunikation gezeigt. Die Vorrichtung 10 ist vorliegend daher nicht nur als eine Sensorvorrichtung 10, sondern auch als eine Kommunikationsvorrichtung 10 ausgebildet, bei welcher das Kommunikationsmittel 61 durch eine Verarbeitungsanordnung 65 als Kommunikationsschnittstelle betrieben werden kann.

Das Kommunikationsmittel 61 ist in der Form einer Schleifen- bzw. Rahmenantenne (sogenannte Loop) ausgebildet, und kann zum Senden und/oder Empfangen von Signalen für die Nahfeldkommunikation mit einem mobilen Gerät dienen. Die Kopplung zwischen der Kommunikationsvorrichtung 10 und dem mobilen Gerät kann bei einer Betriebsfrequenz des Kommunikationsmittels 61 von 13,56 MHz erfolgen. Entsprechend kann das Kommunikationsmittel 61 dazu ausgeführt sein, ein Magnetfeld zur Kommunikation mit dem mobilen Gerät zu erzeugen und auf diese Weise eine induktive Kopplung mit dem mobilen Gerät herzustellen. Daher kann die NFC-Antenne 61 auch als NFC-Spule verstanden werden. Das Kommunikationsmittel 61 kann vorteilhafterweise als eine Leiterschleife auf der Leiterplatte 20 ausgebildet sein. Die in Figur 8 gezeigte Form erstreckt sich allerdings in der Weise nicht durchgehend auf einer einzigen Lage der Leiterplatte 20. Vielmehr wird diese Form an einigen Stellen von Durchkontaktierungen 25 unterbrochen und ausgehend von dieser Unterbrechung an einer anderen Lage weiter fortgesetzt. Würde man den Verlauf des Kommunikationsmittels 61 auf sämtlichen Lagen 21, 22, 23, 24 in einer Ebene zusammenbringen, könnte man also den in Figur 8 gezeigten Verlauf erhalten.

Deutlich wird in Figur 8, dass die gezeigte Form des Kommunikationsmittels 61 geometrisch symmetrisch ist (in Bezug auf den Punkt V, durch welchen die entsprechende Symmetrieachse S verlaufen kann). Diese geometrische Symmetrie bewirkt eine Reduzierung von Störeinflüssen. Gleichzeitig kann das Kommunikationsmittel 61 gemäß einer elektrischen Symmetrierung betrieben werden, bei welcher die Ansteuerung und/oder Signalführung durch die Verarbeitungsanordnung 65 über die beiden Zweige bei RX+ und RX- symmetrisch bzw. differenziell durchgeführt werden kann (im Gegensatz zu einem Betrieb, bei dem einer der Anschlüsse des Kommunikationsmittels 61 mit Masse verbunden ist). Vorteilhafterweise ist daher an beiden Anschlüssen RX+ und RX- jeweils ein elektrisches Signal, insbesondere eine Spannung ungleich 0 Volt, messbar, welches Informationen der Nahfeldkommunikation umfasst. Die Spannung an den Anschlüssen RX+ und RX- kann symmetrisch und somit betragsgleich sein. Die Verarbeitungsanordnung 65 ist bspw. als ein NFC-Receiver oder -Transceiver ausgeführt.

Bei dem gezeigten symmetrischen Design kann eine virtuelle Masse genau oder im Wesentlichen am zentralen Punkt V des Kommunikationsmittels 61 lokalisiert sein. Dieser zentrale Punkt V kann, wie in Figur 8 dargestellt ist, am Ort der halben Länge bzw. der Mitte des Kommunikationsmittels 61 liegen. Je nach Antennendesign kann es möglich sein, dass durch einen Abgriff an diesem Punkt V mit Verbindung zur Masse bei einer idealen Antenne kein Strom fließt. Dieser Punkt V wird daher im Folgenden als virtuelle Masse bezeichnet.

Bereits durch die geometrische und elektrische Symmetrierung können Störeinflüsse in der Art von störenden Immissionen (elektromagnetischer Einstrahlung) reduziert werden. Dennoch bleiben störende Effekte, welche bewirken, dass parasitäre Schwingkreise des Kommunikationsmittels 61 angeregt werden. Hierbei können harmonische und nicht harmonische Schwingungen entstehen, wobei die nicht harmonischen Schwingungen ggf. von der Verarbeitungsanordnung 65 und/oder durch eine Filteranordnung 70 reduziert werden. Dennoch sind die harmonischen Schwingungen weiterhin störend, und können den Empfang bei der Nahfeldkommunikation durch das Kommunikationsmittel 61 beeinträchtigen.

Um Störungen beim Empfang der Nahfeldkommunikation durch störende Immissionen, insbesondere EMV-Einstrahlung, weiter zu reduzieren, kann an der Position der (idealen) virtuellen Masse V eine resistive Dämpfung vorgesehen sein. Das heißt, an dieser Position kann ein ohmscher Widerstand oder eine Impedanz als Dämpfungswiderstand Rd genutzt werden, welcher das Kommunikationsmittel 61 mit einem elektrischen Massepotential verbindet. Dieser Dämpfungswiderstand Rd kann als ein niederohmiger Widerstand zum Beispiel im Bereich von 50 bis 100 Ohm ausgeführt sein. Funktional kann die resistive Dämpfung durch den Dämpfungswiderstand Rd bewirken, dass auch bei einer Veränderung der Position der virtuellen Masse an dem Kommunikationsmittel 61 durch das Auftreten der Störungen die störenden Schwingungen durch den Widerstand Rd gedämpft werden.

Zusätzlich kann zur weiteren Stabilisierung des Systems vorgesehen sein, dass das Kommunikationsmittel 61 zumindest überwiegend parallel zum Außenrand und/oder mit gleichbleibenden Abstand zur elektrischen Masse 45, insbesondere Massefläche 45, an der Leiterplatte 20 angeordnet ist. Die Masse 45 ist in Figur 5 in der Form einer Leiterfläche mit Massepotential ausgebildet. In Figur 5 ist auch der konstante Abstand zwischen der Massefläche 45 und dem Kommunikationsmittel 61 erkennbar. Auf diese Weise kann gewährleistet werden, dass eine magnetische Ankopplung des Kommunikationsmittels 61 zur Masse 45 an jeder Stelle gleich ist.

Darüber hinaus kann für die Filteranordnung 70 ein Bandpass-Filter, vorzugsweise 2. Ordnung, insbesondere ein sogenannter Wien-Filter, eingesetzt werden, welcher durch eine besonders steile Bandpasskurve eine verbesserte Herausfilterung der Störungen bewirkt. Das Wien-Filter ist ein speziell geschalteter RC-Bandpass, und auch bekannt als die Frequenz bestimmende Schaltung in einem Wien-Robinson-Generator.

In Figur 8 ist gezeigt, dass sich die Filteranordnung 70 aus zumindest einer Hochpassanordnung 71 (insbesondere ein RC-Filter 1. Ordnung) und zumindest einer Tiefpassanordnung 72 (insbesondere auch als ein RC-Filter 1. Ordnung) zusammensetzen kann. Die Hochpass- und Tiefpassanordnung 71, 72 können sich paarweise zu dem Bandpass-Filter, insbesondere einem RC-Filter 2. Ordnung, zusammensetzen. Dieses Bandpass-Filter, insbesondere das Wien-Filter, kann dabei symmetrisch bei der Filteranordnung 70 vorgesehen sein.

Konkret kann ein Widerstand R1 und ein Kondensator C1 in serieller Verschaltung vorgesehen sein. Optional ist ein weiterer Widerstand R3 vorgesehen, welcher einen zusätzlichen Spannungsteiler mit R1 bildet. Weiter kann ein Widerstand R2 und ein Kondensator C2 parallelgeschaltet sein.

Ferner ist in Figur 8 erkennbar, dass die beschriebene Filteranordnung 70 das Bandpass-Filter symmetrisch für die Anschlüsse RX+ und RX- aufweist. Ein möglicher Wert für den jeweiligen Widerstand R1 liegt dabei im Bereich von 1 bis 10 kOhm, für den jeweiligen Widerstand R3 zwischen 1 und 5 kOhm, für den jeweiligen Kondensator C1 zwischen 1 bis 20 pF, für den jeweiligen Widerstand R2 zwischen 100 bis 500 Ohm und für den jeweiligen Kondensator C2 zwischen 10 und 40 pF. Damit kann zumindest ein Bandpass-Filter durch die Filteranordnung 70 bereitgestellt werden, welches eine deutliche Abschwächung von Signalen des Kommunikationsmittels 61 im Bereich von z. B. 100 bis 160 MHz bewirkt.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen. Der Rahmen der vorliegenden Erfindung wird durch den Schutzumfang der Ansprüche definiert.

### Bezuaszeichenliste

- 1: Fahrzeug
- 2: Tür
- 5: Türgriff, Fahrzeugteil
- 6: Heckklappe
- 7: Türgriffmulde

- 10: Vorrichtung, Sensor- und/oder Kommunikationsvorrichtung

- 20: Leiterplatte
- 21: erste Lage
- 22: zweite Lage
- 23: dritte Lage
- 24: vierte Lage
- 25: Durchkontaktierung
- 28: Bereich für Elektronikbauteile
- 29: Verarbeitungsvorrichtung

- 31: Sensorelement, erstes Sensorelement
- 32: zweites Sensorelement
- 35: deckungsgleiche Bereiche
- 36: Teilstruktur, Linienstruktur

- 40: Abschirmelement
- 41: Abschirmung
- 42: Unterbrechung
- 45: Masse

- 51: Detektionsbereich, erster Detektionsbereich
- 52: zweiter Detektionsbereich
- 61: Kommunikationsmittel, Antenne, NFC-Loop
- 65: Verarbeitungsanordnung

- 70: Filteranordnung
- 71: Hochpassanordnung
- 72: Tiefpassanordnung

- x: erste Richtung, laterale Richtung
- y: zweite Richtung, laterale Richtung
- z: dritte Richtung, axiale Richtung
- 21, 22, 23, 24: Lagen
- A: Abstand, Mindestabstand
- B: Versatz
- C: Kondensator
- R: Widerstand
- Rd: Dämpfungswiderstand
- RX: Anschluss
- V: Virtuelle Masse
- S: Symmetrieachse

## Patentansprüche

1. Vorrichtung (10) für ein Fahrzeug (1) zur Detektion einer Aktivierungshandlung in mindestens zwei unterschiedlichen Detektionsbereichen (51, 52), und insbesondere zur Montage an einem Fahrzeugteil (5), um mindestens eine Funktion des Fahrzeuges (1) in Abhängigkeit von der Detektion zu aktivieren, aufweisend:
- eine Leiterplatte (20) mit mehreren Lagen (21, 22, 23, 24), welche in einer axialen Richtung (z) übereinander angeordnet sind,
- ein erstes elektrisch leitendes Sensorelement (31) zur kapazitiven Erfassung in einem ersten (51) der Detektionsbereiche (51, 52),
- ein zweites elektrisch leitendes Sensorelement (32) zur kapazitiven Erfassung in einem zweiten (52) der Detektionsbereiche (51, 52),
wobei die Sensorelemente (31, 32) an unterschiedlichen der Lagen (21, 22, 23, 24) der Leiterplatte (20) angeordnet sind,
**dadurch gekennzeichnet,**
**dass** die Sensorelemente (31, 32) zumindest teilweise deckungsgleich ausgebildet sind, wobei die deckungsgleichen Bereiche (35) der Sensorelemente (31, 32) in einer lateralen Richtung (x) zueinander versetzt positioniert sind, wobei die Sensorelemente (31, 32) jeweils eine Teilstruktur (36) aufweisen, welche sich zumindest in einem bestimmten Mindestabstand (A) in der lateralen Richtung (x) wiederholt, wobei die zueinander versetzte Positionierung der Sensorelemente (31, 32) in der gleichen lateralen Richtung (x) erfolgt.

2. Vorrichtung (10) nach Anspruch 1,
**dadurch gekennzeichnet,**
**dass** die zueinander versetzte Positionierung der Sensorelemente (31, 32) mit einem bestimmten Versatz (B) vorgesehen ist, welcher maximal der Hälfte des Mindestabstands (A) der Teilstrukturen (36) entspricht.

3. Vorrichtung (10) nach einem der vorhergehenden Ansprüche,
**dadurch gekennzeichnet,**
**dass** die versetzte Positionierung als eine unterschiedliche Positionierung der Sensorelemente (31, 32) innerhalb der jeweiligen Lage (21, 22, 23, 24) ausgeführt ist, sodass eine Überlappung der Sensorelemente (31, 32) verhindert ist, und insbesondere durch die Sensorelemente (31, 32) erzeugte elektrische Felder versetzt ausgebildet werden.

4. Vorrichtung (10) nach einem der vorhergehenden Ansprüche,
**dadurch gekennzeichnet,**
**dass** die deckungsgleichen Bereiche (35) der Sensorelemente (31, 32) gleich ausgebildete Teilstrukturen (36) aufweisen, insbesondere in der Form einer Linienstruktur (36).

5. Vorrichtung (10) nach Anspruch 4,
**dadurch gekennzeichnet,**
**dass** hinsichtlich der lateralen Richtung (x) die Teilstrukturen (36), insbesondere die Linien, des zweiten Sensorelements (32) zwischen den Teilstrukturen (36), insbesondere den Linien, des ersten Sensorelements (31) angeordnet sind.

6. Vorrichtung (10) nach einem der vorhergehenden Ansprüche,
**dadurch gekennzeichnet,**
**dass** das zweite Sensorelement (32) eine längere Erstreckung aufweist als das erste Sensorelement (31), sodass der zweite Detektionsbereich (52) größer als der erste Detektionsbereich (51) ausgeführt ist.

7. Vorrichtung (10) nach einem der vorhergehenden Ansprüche,
**dadurch gekennzeichnet,**
**dass** ein Abschirmelement (40) an einer zweiten Lage (22) der Leiterplatte (20) vorgesehen ist, und zumindest teilweise eine deckungsgleiche Ausbildung zum ersten Sensorelement (31) an einer ersten Lage (21) der Leiterplatte (20) und zumindest teilweise zum zweiten Sensorelement (32) an einer weiteren, insbesondere vierten, Lage (24) der Leiterplatte (20) aufweist, und in der lateralen Richtung (x) positionsgleich zum ersten Sensorelement (31) sowie versetzt zum zweiten Sensorelement (32) positioniert ist.

8. Vorrichtung (10) nach einem der vorhergehenden Ansprüche,
**dadurch gekennzeichnet,**
**dass** eine Verarbeitungsvorrichtung (29) an der Leiterplatte (20) angeordnet ist, und elektrisch für Ladungsübertragungen mit den Sensorelementen (31, 32) verbunden ist, um anhand der Ladungsübertragungen eine veränderliche elektrische Kapazität des jeweiligen Sensorelements (31, 32) auszuwerten und hierdurch die jeweilige kapazitive Erfassung bereitzustellen.

9. Vorrichtung (10) nach Anspruch 8,
**dadurch gekennzeichnet,**
**dass** die Verarbeitungsvorrichtung (29) dazu ausgeführt ist, die Detektion der Aktivierungshandlung derart durchzuführen, dass eine Annäherung und/oder eine Geste eines Benutzers anhand der Auswertung der jeweiligen Kapazität detektiert wird, und zwischen einer ersten Aktivierungshandlung im ersten Detektionsbereich (51) und einer zweiten Aktivierungshandlung im zweiten Detektionsbereich (52) unterschieden wird.

10. Vorrichtung (10) nach Anspruch 8 oder 9,
**dadurch gekennzeichnet,**
**dass** das erste Sensorelement (31) an einer ersten Lage (21) angrenzend zum ersten Detektionsbereich (51) ausgebildet ist, und das zweite Sensorelement (32) an einer weiteren, insbesondere vierten, Lage (24) angrenzend zum zweiten Detektionsbereich (52) ausgebildet ist, wobei die jeweiligen Lagen (21, 24) als äußere Lagen der Leiterplatte (20) vorgesehen sind, um die Detektionsbereiche (51, 52) durch die Sensorelemente (31, 32) auf unterschiedlichen Seiten eines Türgriffs (5) des Fahrzeuges (1) über die jeweilige veränderliche elektrische Kapazität der Sensorelemente (31, 32) auszubilden, sodass anhand der Kapazitäten eine erste Aktivierungshandlung im ersten Detektionsbereich (51) von einer zweiten Aktivierungshandlung im zweiten Detektionsbereich (52) unterschieden wird, um gemäß der Unterscheidung unterschiedliche Funktionen des Fahrzeuges (1) zu aktivieren.

11. Vorrichtung (10) nach einem der vorhergehenden Ansprüche,
**dadurch gekennzeichnet,**
**dass** ein Kommunikationsmittel (61) auf den Lagen (21, 22, 23, 24) der Leiterplatte (20) angeordnet ist, und vorzugsweise sich über sämtliche der Lagen (21, 22, 23, 24) beabstandet zu den Sensorelementen (31, 32) sich erstreckt, um eine Nahfeldkommunikation mit einem mobilen Gerät außerhalb des Fahrzeuges (1) bereitzustellen, und vorzugsweise um ausgelöst durch die Detektion der Aktivierungshandlung eine Authentifizierung über die Nahfeldkommunikation durchzuführen, und um bevorzugt abhängig von der Authentifizierung die wenigstens eine Funktion des Fahrzeuges (1), insbesondere eine Entriegelung und/oder Verriegelung des Fahrzeuges (1), zu aktivieren.

12. Vorrichtung (10) nach einem der vorhergehenden Ansprüche,
**dadurch gekennzeichnet,**
**dass** die versetzte Positionierung der Sensorelemente (31, 32) derart als eine unterschiedliche Positionierung der Sensorelemente (31) in der lateralen Richtung (x, y) ausgeführt ist, dass eine Störung durch die kapazitive Erfassung des ersten Sensorelements (31) im ersten Detektionsbereich (51) auf die kapazitive Erfassung des zweiten Sensorelements (32) im zweiten Detektionsbereich (52) reduziert wird.

13. Vorrichtung (10) nach einem der vorhergehenden Ansprüche,
**dadurch gekennzeichnet,**
**dass** der jeweilige deckungsgleiche Bereich der Sensorelemente (31, 32) eine sich wiederholende Teilstruktur (36) aufweist, welche dazu ausgebildet ist, ein elektrisches Feld zur jeweiligen kapazitiven Erfassung auszubilden, und derart ausgerichtet und/oder angeordnet ist, dass eine störende Wechselwirkung zu einem Kommunikationsmittel (61) der Leiterplatte (20) verringert wird.

14. Türgriff (5) für ein Fahrzeug (1), welches als das Fahrzeugteil (5) eine Vorrichtung (10) nach einem der vorhergehenden Ansprüche aufweist.

## Claims

1. Device (10) for a vehicle (1) for detecting an activation action in at least two different detection areas (51, 52), and in particular for mounting on a vehicle part (5) in order to activate at least one function of the vehicle (1) as a function of the detection, having:
- a printed circuit board (20) with several layers (21, 22, 23, 24), which are arranged one above the other in an axial direction (z),
- a first electrically conductive sensor element (31) for capacitive detection in a first (51) of the detection areas (51, 52),
- a second electrically conductive sensor element (32) for capacitive detection in a second (52) of the detection areas (51, 52),
wherein the sensor elements (31, 32) are arranged on different ones of the layers (21, 22, 23, 24) of the printed circuit board (20),
**characterized in that**
the sensor elements (31, 32) are designed to be at least partially congruent, the congruent regions (35) of the sensor elements (31, 32) being positioned offset with respect to one another in a lateral direction (x), the sensor elements (31, 32) each having a substructure (36) which is repeated at least at a specific minimum distance (A) in the lateral direction (x), the positioning of the sensor elements (31, 32) offset with respect to one another taking place in the same lateral direction (x).

2. Device (10) according to claim 1,
**characterized in that**
the offset positioning of the sensor elements (31, 32) is provided with a specific offset (B), which corresponds to a maximum of half the minimum distance (A) between the substructures (36).

3. Device (10) according to one of the preceding claims,
**characterized in that**
the offset positioning is implemented as a different positioning of the sensor elements (31, 32) within the respective layer (21, 22, 23, 24), so that overlapping of the sensor elements (31, 32) is prevented, and in particular electric fields generated by the sensor elements (31, 32) are formed in an offset manner.

4. Device (10) according to one of the preceding claims,
**characterized in that**
the congruent areas (35) of the sensor elements (31, 32) have identically formed substructures (36), in particular in the form of a line structure (36).

5. Device (10) according to claim 4,
**characterized in that**
with respect to the lateral direction (x), the substructures (36), in particular the lines, of the second sensor element (32) are arranged between the substructures (36), in particular the lines, of the first sensor element (31).

6. Device (10) according to one of the preceding claims,
**characterized in that**
the second sensor element (32) has a longer extension than the first sensor element (31), so that the second detection area (52) is larger than the first detection area (51).

7. Device (10) according to one of the preceding claims,
**characterized in that**
a shielding element (40) is provided on a second layer (22) of the printed circuit board (20), and is at least partially congruent with the first sensor element (31) on a first layer (21) of the printed circuit board (20) and at least partially with the second sensor element (32) on a further, in particular fourth, layer (24) of the printed circuit board (20), and is positioned in the same position as the first sensor element (31) and offset from the second sensor element (32) in the lateral direction (x).

8. Device (10) according to one of the preceding claims,
**characterized in that**
a processing device (29) is arranged on the printed circuit board (20) and is electrically connected to the sensor elements (31, 32) for charge transfers, in order to evaluate a variable electrical capacitance of the respective sensor element (31, 32) on the basis of the charge transfers and thereby provide the respective capacitive detection.

9. Device (10) according to claim 8,
**characterized in that**
the processing device (29) is designed to perform the detection of the activation action in such a way that an approach and/or a gesture of a user is detected on the basis of the evaluation of the respective capacitance, and a distinction is made between a first activation action in the first detection area (51) and a second activation action in the second detection area (52).

10. Device (10) according to claim 8 or 9,
**characterized in that**
the first sensor element (31) is formed on a first layer (21) adjacent to the first detection area (51), and the second sensor element (32) is formed on a further, in particular fourth, layer (24) adjacent to the second detection area (52), the respective layers (21, 24) being provided as outer layers of the printed circuit board (20) in order to form the detection areas (51, 52) by the sensor elements (31, 32) on different sides of a door handle (5) of the vehicle (1) via the respective variable electrical capacitance of the sensor elements (31, 32), so that a first activation action in the first detection area (51) is differentiated from a second activation action in the second detection area (52) on the basis of the capacitances, in order to activate different functions of the vehicle (1) in accordance with the differentiation.

11. Device (10) according to one of the preceding claims,
**characterized in that**
a communication means (61) is arranged on the layers (21, 22, 23, 24) of the printed circuit board (20) and preferably extends over all of the layers (21, 22, 23, 24) at a distance from the sensor elements (31, 32) in order to provide near-field communication with a mobile device outside the vehicle (1), and preferably to perform an authentication via the near-field communication triggered by the detection of the activation action, and preferably to activate the at least one function of the vehicle (1), in particular unlocking and/or locking of the vehicle (1), depending on the authentication.

12. Device (10) according to one of the preceding claims,
**characterized in that**
the offset positioning of the sensor elements (31, 32) is implemented as a different positioning of the sensor elements (31) in the lateral direction (x, y) in such a way that an interference caused by the capacitive detection of the first sensor element (31) in the first detection area (51) is reduced to the capacitive detection of the second sensor element (32) in the second detection area (52).

13. Device (10) according to one of the preceding claims,
**characterized in that**
the respective congruent region of the sensor elements (31, 32) has a repeating substructure (36) which is designed to form an electric field for the respective capacitive detection and is aligned and/or arranged in such a way that an interfering interaction with a communication means (61) of the printed circuit board (20) is reduced.

14. Door handle (5) for a vehicle (1), which comprises as the vehicle part (5) a device (10) according to one of the preceding claims.

## Revendications

1. Dispositif (10) pour un véhicule (1) pour un détection d'une action d'activation dans au moins deux zones de détection (51, 52) différentes, et destiné notamment à être monté sur une partie (5) du véhicule pour activer au moins une fonction du véhicule (1) en fonction de la détection :
- une carte de circuit imprimé (20) comprenant plusieurs couches (21, 22, 23, 24) qui sont superposées dans une direction axiale (z),
- un premier élément de détection électriquement conducteur (31) pour la détection capacitive dans une première (51) des zones de détection (51, 52),
- un deuxième élément de détection électriquement conducteur (32) pour la détection capacitive dans une deuxième (52) des zones de détection (51, 52),
les éléments de détection (31, 32) étant disposés sur différentes des couches (21, 22, 23, 24) de la carte de circuit imprimé (20),
**caractérisé en ce que**
les éléments de détection (31, 32) sont réalisés au moins partiellement en coïncidence, les zones (35) en coïncidence des éléments de détection (31, 32) étant positionnées de manière décalée les unes par rapport aux autres dans une direction latérale (x), les éléments de détection (31, 32) présentant chacun une structure partielle (36) qui se répète au moins à une distance minimale (A) déterminée dans la direction latérale (x), le positionnement décalé les uns par rapport aux autres des éléments de détection (31, 32) s'effectuant dans la même direction latérale (x).

2. Dispositif (10) selon la revendication 1,
**caractérisé en ce que**
le positionnement décalé l'un par rapport à l'autre des éléments de détection (31, 32) est prévu avec un décalage déterminé (B) qui correspond au maximum à la moitié de la distance minimale (A) des structures partielles (36).

3. Dispositif (10) selon l'une des revendications précédentes,
**caractérisé en ce que**
le positionnement décalé est réalisé sous la forme d'un positionnement différent des éléments de détection (31, 32) à l'intérieur de la couche respective (21, 22, 23, 24), de sorte qu'un chevauchement des éléments de détection (31, 32) est empêché, et en particulier des champs électriques générés par les éléments de détection (31, 32) sont réalisés de manière décalée.

4. Dispositif (10) selon l'une des revendications précédentes,
**caractérisé en ce que**
les zones (35) coïncidentes des éléments de détection (31, 32) présentent des structures partielles (36) de même configuration, en particulier sous la forme d'une structure linéaire (36).

5. Dispositif (10) selon la revendication 4,
**caractérisé en ce que,**
, en ce qui concerne la direction latérale (x), les structures partielles (36), en particulier les lignes, du deuxième élément de détection (32) sont disposées entre les structures partielles (36), en particulier les lignes, du premier élément de détection (31).

6. Dispositif (10) selon l'une des revendications précédentes,
**caractérisé en ce que**
le deuxième élément de détection (32) présente une extension plus longue que le premier élément de détection (31), de sorte que la deuxième zone de détection (52) est réalisée plus grande que la première zone de détection (51).

7. Dispositif (10) selon l'une des revendications précédentes,
**caractérisé en ce que**
un élément de blindage (40) est prévu sur une deuxième couche (22) de la carte de circuit imprimé (20), et présente au moins partiellement une configuration en coïncidence avec le premier élément de détection (31) sur une première couche (21) de la carte de circuit imprimé (20) et au moins partiellement avec le deuxième élément de détection (32) sur une autre couche (24), en particulier la quatrième, de la carte de circuit imprimé (20), et est positionné dans la direction latérale (x) dans la même position que le premier élément de détection (31) ainsi que décalé par rapport au deuxième élément de détection (32).

8. Dispositif (10) selon l'une des revendications précédentes,
**caractérisé en ce que**
un dispositif de traitement (29) est disposé sur la carte de circuit imprimé (20) et est relié électriquement aux éléments de détection (31, 32) pour des transferts de charge, afin d'évaluer à l'aide des transferts de charge une capacité électrique variable de l'élément de détection respectif (31, 32) et de fournir ainsi la détection capacitive respective.

9. Dispositif (10) selon la revendication 8,
**caractérisé en ce que**
le dispositif de traitement (29) est réalisé pour effectuer la détection de l'action d'activation de telle sorte qu'une approche et/ou un geste d'un utilisateur sont détectés à l'aide de l'évaluation de la capacité respective, et une distinction est faite entre une première action d'activation dans la première zone de détection (51) et une deuxième action d'activation dans la deuxième zone de détection (52).

10. Dispositif (10) selon la revendication 8 ou 9,
**caractérisé en ce que**
le premier élément de détection (31) est formé sur une première couche (21) adjacente à la première zone de détection (51), et le deuxième élément de détection (32) est formé sur une autre couche (24), en particulier la quatrième, adjacente à la deuxième zone de détection (52), les couches respectives (21, 24) étant prévues en tant que couches extérieures de la carte de circuit imprimé (20), afin de déterminer les zones de détection (51, 52) par les éléments de détection (31, 32) sur différents côtés d'une poignée de porte (5) du véhicule (1) par l'intermédiaire de la capacité électrique variable respective des éléments de détection (31, 32), de sorte qu'à l'aide des capacités, une première action d'activation dans la première zone de détection (51) est distinguée d'une deuxième action d'activation dans la deuxième zone de détection (52), afin d'activer différentes fonctions du véhicule (1) conformément à la distinction.

11. Dispositif (10) selon l'une des revendications précédentes,
**caractérisé en ce que**
un moyen de communication (61) est disposé sur les couches (21, 22, 23, 24) de la carte de circuit imprimé (20), et s'étend de préférence sur toutes les couches (21, 22, 23, 24) à distance des éléments de détection (31, 32), pour fournir une communication en champ proche avec un appareil mobile à l'extérieur du véhicule (1), et de préférence pour effectuer une authentification par la communication en champ proche, déclenchée par la détection de l'action d'activation, et pour activer de préférence en fonction de l'authentification l'au moins une fonction du véhicule (1), en particulier un déverrouillage et/ou un verrouillage du véhicule (1).

12. Dispositif (10) selon l'une des revendications précédentes,
**caractérisé en ce que**
le positionnement décalé des éléments de détection (31, 32) est réalisé sous la forme d'un positionnement différent des éléments de détection (31) dans la direction latérale (x, y) de telle sorte qu'une perturbation par la détection capacitive du premier élément de détection (31) dans la première zone de détection (51) est réduite à la détection capacitive du deuxième élément de détection (32) dans la deuxième zone de détection (52).

13. Dispositif (10) selon l'une des revendications précédentes,
**caractérisé en ce que**
la zone respective en coïncidence des éléments de détection (31, 32) présente une structure partielle (36) répétitive qui est conçue pour former un champ électrique pour la détection capacitive respective, et est orientée et/ou disposée de telle sorte qu'une interaction perturbatrice avec un moyen de communication (61) de la carte de circuit imprimé (20) est réduite.

14. Poignée de porte (5) pour un véhicule (1), qui comprend, en tant que partie du véhicule (5), un dispositif (10) selon l'une des revendications précédentes.
